# EUROPEAN PATENT APPLICATION

(11) **EP 4 718 717 A1**
(43) Date of publication of application: **01.04.2026**
(21) Application number: 25201335.4
(22) Date of filing: 10.09.2025
(51) Int. Cl.: H03F 3/45

(54) **TWO-STAGE IMPROVED OPERATIONAL AMPLIFIER**

(30) Priority: 27.09.2024 IT 202400021496
(71) Applicant: STMicroelectronics International N.V., 1228 Plan-les-Ouates, Geneva (CH)
(72) Inventor: FEMIA, Aldo, 20125 Milano (IT); BARBIERI, Andrea, 26841 Casalpusterlengo (LO) (IT); ZAMPROGNO, Marco, 20811 Cesano Maderno (MB) (IT); BONINI, Mattia, 26010 Ripalta Cremasca (CR) (IT)
(74) Representative: Studio Torta S.p.A.

(57) **Abstract**

Operational amplifier (30) comprising: a first stage (32) of the current-reuse type; and a second stage (34) of the rail-to-rail type, cascaded with respect to the first stage (32). The first stage (32) comprises a first feedback assembly (32') configured to define a first feedback loop, independent of the second stage (34).

## Description

### TECHNICAL FIELD

The present invention relates to a two-stage improved operational amplifier.

### BACKGROUND

Operational amplifiers are commonly used electronic components, especially in the field of analog circuits, which have numerous significant advantages such as an overall closed loop gain dependent on the components external to the amplifier and therefore little dependent on factors such as the frequency of the input signal or temperature.

The operational transconductance amplifier (OTA) is an analog electronic circuit that may be considered one of the simplest and most common implementations of an operational amplifier.

A typical and known implementation of the OTA occurs by using CMOS ("Complementary Metal-Oxide-Semiconductor") technology, in particular using MOSFET (Metal-Oxide-Semiconductor Field-Effect Transistors) devices.

One of the critical parameters in the operation of the OTA is its noise (in detail the input noise). In fact, in the OTA the noise is inversely proportional to the current, and therefore to the input power, required for the operation of the OTA. This implies that normally, in order to reduce noise in the OTA, it is required to increase its power consumption.

The input noise of an OTA is mainly due to the input differential pair of the OTA and the applied electronic load. Typically, the noise at the input of an OTA is about two to three times the noise of a single transistor of the input differential pair, and is inversely proportional to the tail current (i.e., the biasing current of the input differential pair) of the OTA.

A new low-noise input stage for the OTA has been proposed recently that, for the same tail current, has an input noise equal to that of a single transistor. This new input stage is based on current reuse, i.e., on the use of the same input current to bias multiple devices in order to reduce the overall energy consumption.

This new stage with current reuse has been applied to an OTA structure known as a two-stage OTA. The first stage is the one with current reuse and is designed to ensure low-noise performances, while the second stage is designed to allow a rail-to-rail output (i.e. allow the output voltage to have a range that goes from values proximate to the negative power supply to values proximate to the positive power supply). The two-stage OTA therefore allows both these benefits to be obtained.

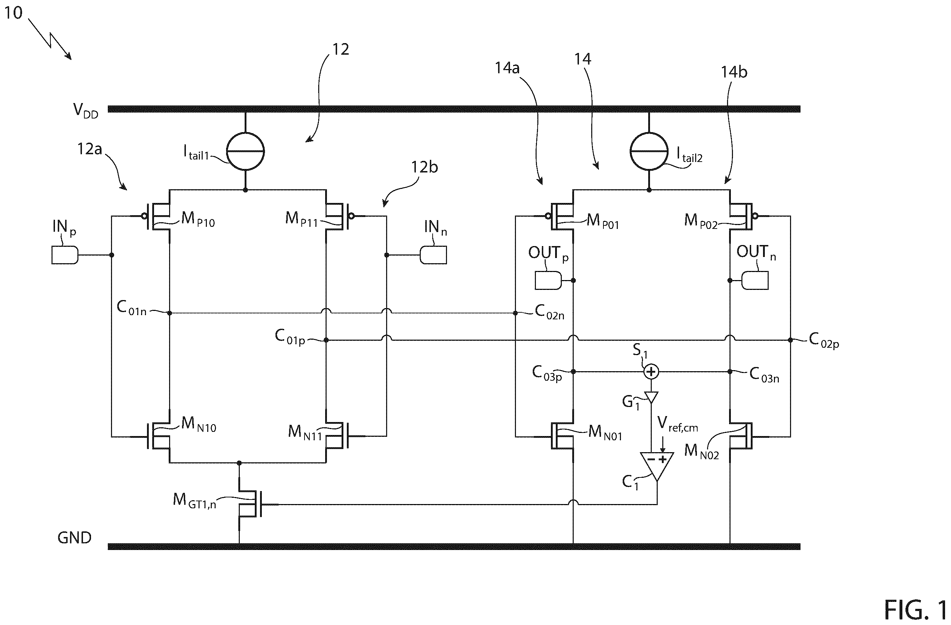

Figure 1 shows a known example of an OTA 10 having two stages.

The OTA 10 is biased with a first supply rail set to a maximum supply voltage V_{DD} and with a second supply rail set to a minimum supply voltage (here a reference voltage equal to a ground voltage GND). Therefore, in the following, the first and the second supply rails are also more briefly referred to as the first and the second rails V_{DD} and GND, respectively.

The OTA 10 comprises the first stage 12 with current reuse and the second stage 14 not of the rail-to-rail type, cascaded to each other.

The first stage 12 comprises a first inverter (or first first-stage inverter) 12a and a second inverter (or second first-stage inverter) 12b, connected in parallel with each other between the first and the second rails V_{DD} and GND.

The first and the second inverters 12a and 12b are made by using CMOS technology. In other words, the first inverter 12a comprises a MOSFET M_{P10} of the P-type and an MOSFET M_{N10} of the N-type, complementary to each other, and the second inverter 12b comprises a MOSFET M_{P11} of the P-type and a MOSFET M_{N11} of the N-type, complementary to each other.

In detail, the first stage 12 also comprises a first tail current generator, configured to generate a first tail current Iₜₐᵢₗ₁ and therefore hereinafter also referred to more simply as the first current generator Iₜₐᵢₗ₁, and a control MOSFET M_{GT1,n}, of the N-type. The first current generator Iₜₐᵢₗ₁ is directly connected to the first rail V_{DD}, the source terminal of the control MOSFET M_{GT1,n} is directly connected to the second rail GND and the first and the second inverters 12a and 12b are directly connected, in parallel with each other, between the first current generator Iₜₐᵢₗ₁ and the drain terminal of the control MOSFET M_{GT1,n}.

The gate terminals of the MOSFETs M_{P10} and M_{N10} are directly coupled to a positive (or non-inverting) input INₚ of the OTA 10, and the gate terminals of the MOSFETs M_{P11} and M_{N11} are directly coupled to a negative (or inverting) input INₙ of the OTA 10.

The source terminals of the MOSFETs M_{P10} and M_{P11} are directly connected to the first current generator Iₜₐᵢₗ₁, the source terminals of the MOSFETs M_{N10} and M_{N11} are directly connected to the drain terminal of the control MOSFET M_{GT1,n}, the drain terminals of the MOSFETs M_{P10} and M_{N10} are directly coupled to each other at a first negative (or inverting) common node C₀₁ₙ, and the drain terminals of MOSFETs M_{P11} and M_{N11} are directly coupled to each other at a first positive (or non-inverting) common node C₀₁ₚ.

Furthermore, the second stage 14 comprises a first inverter (or first second-stage inverter) 14a and a second inverter (or second second-stage inverter) 14b, connected in parallel with each other between the first and the second rails V_{DD} e GND.

The first and the second inverters 14a and 14b are made by using CMOS technology. In other words, the first inverter 14a comprises a MOSFET M_{P01} of the P-type and a MOSFET M_{N01} of the N-type, complementary to each other, and the second inverter 14b comprises a MOSFET M_{P02} of the P-type and a MOSFET M_{N02} of the N-type, complementary to each other. Consequently, the second stage 14 may be seen as defined by a differential pair M_{P01} and M_{P02} with single-ended amplifiers connected in parallel and formed by MOSFETs M_{N01} and M_{N02}.

The second stage 14 also comprises a second tail current generator, configured to generate a second tail current Iₜₐᵢₗ₂ and therefore hereinafter also referred to more simply as the second current generator Iₜₐᵢₗ₂. The second current generator Iₜₐᵢₗ₂ is directly connected to the first rail V_{DD} and the first and the second inverters 14a and 14b are directly connected, in parallel with each other, between the second current generator Iₜₐᵢₗ₂ and the second rail GND.

The gate terminals of the MOSFETs M_{P01} and M_{N01} are directly coupled to each other at a second negative (or inverting) common node C₀₂ₙ which is short-circuited with the first negative common node C₀₁ₙ, and the gate terminals of the MOSFETs M_{P02} and M_{N02} are directly coupled to each other at a second positive (or non-inverting) common node C₀₂ₚ which is short-circuited with the first positive common node C₀₁ₚ. In this manner, the voltages at the first common nodes C₀₁ₙ and C₀₁ₚ are used to drive the first and the second inverters 14a and 14b, respectively.

The source terminals of the MOSFETs M_{P01} and M_{P02} are directly connected to the second current generator Iₜₐᵢₗ₂, the source terminals of the MOSFETs M_{N01} and M_{N02} are directly connected to the second rail GND, the drain terminals of the MOSFETs M_{P01} and M_{N01} are directly coupled to each other at a third positive (or non-inverting) common node C₀₃ₚ, and the drain terminals of the MOSFETs M_{P02} and M_{N02} are directly coupled to each other at a third negative (or inverting) common node C₀₃ₙ.

The third positive common node C₀₃ₚ is directly connected to a positive (or non-inverting) output of the OTA 10, while the third negative common node C₀₃ₙ is directly connected to a negative (or inverting) output of the OTA 10.

Furthermore, the third positive common node C₀₃ₚ and the third negative common node C₀₃ₙ are both connected to an adder element S₁ of the second stage 14, which in turn is connected to a gain element G₁ of the second stage 14. In detail, the third positive common node C₀₃ₚ and the third negative common node C₀₃ₙ are directly connected to the respective inputs of the adder element S₁, so that the respective voltages are added to each other by the adder element S₁. The output of the adder element S₁ is directly connected to the input of the gain element G₁, which has a gain equal to 0.5. Consequently, the adder element S₁ and the gain element G₁ allow the common mode of the voltages at the third positive common node C₀₃ₚ and at the third negative common node C₀₃ₙ to be calculated.

The output of the gain element G₁ is then compared with a common-mode reference voltage V_{ref,cm}, to calculate its difference and amplify it. In detail, the output of the gain element G₁ is directly connected to a negative (or inverting) input of a subtractor element C₁ of the second stage 14, while the common-mode reference voltage V_{ref,cm} is applied to the positive (or non-inverting) input of the subtractor element C₁. The subtractor element C₁ is provided with a gain Aₛ.

The output of the subtractor element C₁ is then directly connected to the gate terminal of the control MOSFET M_{GT1,n}. In this manner, the output voltage of the subtractor element C₁, determined on the basis of the difference between the common mode of the voltages of the third common nodes C₀₃ₚ and C₀₃ₙ and the common-mode reference voltage V_{ref,cm}, is used to control the operation of the control MOSFET M_{GT1,n} and therefore of the first stage 12.

In other words, the adder element S₁, the gain element G₁, the subtractor element C₁ and the control MOSFET M_{GT1,n} define a common-mode feedback loop that electrically joins the first and the second stages 12 and 14. This loop has the purpose of adjusting the common mode voltage of the second stage 14 at the third common nodes C₀₃ₚ and C₀₃ₙ to the value of the common-mode reference voltage V_{ref,cm}. This adjustment is a property commonly required for fully differential amplifiers.

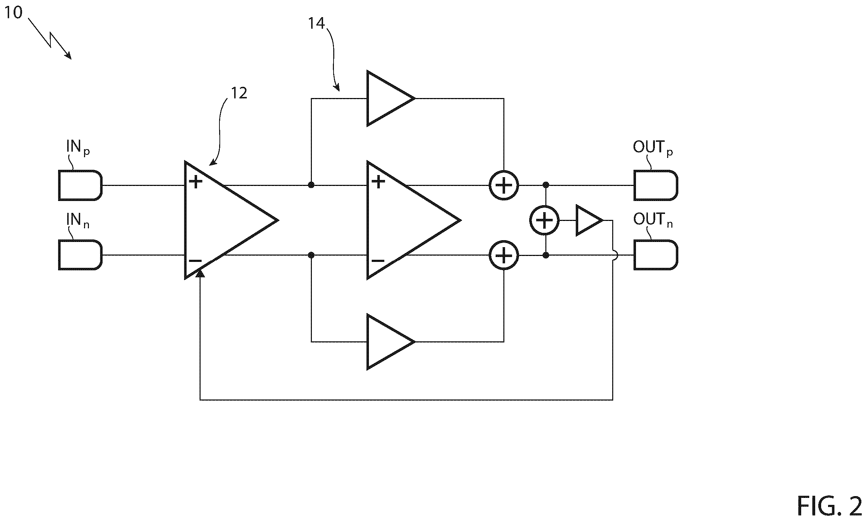

Figure 2 shows a system-level modeling of the OTA 10 of Figure 1.

In particular, it is seen how the amplifier of the first stage 12 is feedback-controlled on the basis of the output of the amplifier of the second stage 14 (formed by the differential pair M_{P01} and M_{P02}, with single-ended amplifiers connected in parallel and formed by the MOSFETs M_{N01} and M_{N02}).

In use, the output common mode of the first stage 12 at the nodes C₀₂ₚ, C₀₂ₙ needs to adequately bias the second stage 14, so that the common-mode output of the second stage 14 is adjusted to the desired value V_{ref,cm}. The first stage 12 needs to be biased at its maximum gain point and the second stage 14, acting as a load for the first stage 12, must not influence the biasing point of the first stage 12. Furthermore, in fully differential amplifiers, the closed-loop amplifier, when turned on, must not latch.

Nevertheless, it has been verified that known two-stage OTAs (e.g., the structure of Figure 1) do not always meet all these requirements.

In particular, the common-mode feedback loop makes the output common mode of the first stage 12 dependent on the output common mode of the second stage 14. Therefore, the first stage 12 is not biased at the maximum gain point.

Furthermore, the output common mode of the first stage 12 is equal to the gate-source voltage V_{gs} of the MOSFETs M_{N01} and M_{N02} at the quiescent point, so the MOSFETs M_{N01} and M_{N02} need to be MOSFETs with a high threshold voltage Vt to be able to set the common mode of the first stage 12 to a reasonable value to obtain high-gain operations (ideally, the optimal common mode would be halfway between the voltages V_{DD} and GND). This implies that the manufacturing process of the OTA 10 requires a greater number of lithographic masks, and that the OTA 10 has a reduced robustness to the "Process-Voltage-Temperature" (PVT) variations. The solutions usable to solve this problem (e.g., based on source followers) require a significant increase in complexity and final cost of the product, and in any case do not solve the problem of biasing at the maximum gain point of the first stage 12.

Furthermore, the topology of the second stage 14 is not of the rail-to-rail type, since the variations of the outputs towards the voltage V_{DD} are limited by the MOSFETs M_{P01} and M_{P02} .

Finally, the common-mode feedback loop makes the OTA 10 subject to the latching problem.

Document US2021135641A1 relates to the technical field of integrated circuits, in particular, to a clock driver circuit with low jitter and high speed, which can be applied to data converters with high requirements for clock circuits in integrated circuits.

Document US2023143127A1 relates generally to amplifiers, and more particularly, to sensing amplifiers.

Document US11190142B1 relates to the field of telecommunication technology, in particular to a signal amplifying circuit device and a receiver.

Document Nicollini G. et al., "A -78dB THD 100Ω Differential Driver for ISDN Applications", IEEE International Solid State Circuits Conference, 1 February 1991 relates to an off-chip buffer capable of driving low-resistive and/or high-capacitive loads.

An aim of the present invention is to provide an operational amplifier that overcomes the drawbacks of the prior art.

### SUMMARY

According to the present invention, an operational amplifier is provided, as defined in the annexed claims which form an integral part of the present description.

### BRIEF DESCRIPTION OF THE DRAWINGS

For a better understanding of the present invention, a preferred embodiment is now described, purely by way of non-limiting example, with reference to the attached drawings, wherein:
- Figure 1 shows the circuit diagram of a two-stage operational amplifier of a known-type;
- Figure 2 shows a system-level modeling of the known operational amplifier of Figure 1;
- Figure 3 shows the circuit diagram of a two-stage operational amplifier, according to one embodiment;
- Figure 4 shows a system-level modeling of the operational amplifier of Figure 3; and
- Figures 5 and 6 show the circuit diagrams of the present two-stage operational amplifier, according to respective and further embodiments.

In the following description, elements common to the different embodiments have been indicated with the same reference numbers.

### DETAILED DESCRIPTION OF THE INVENTION

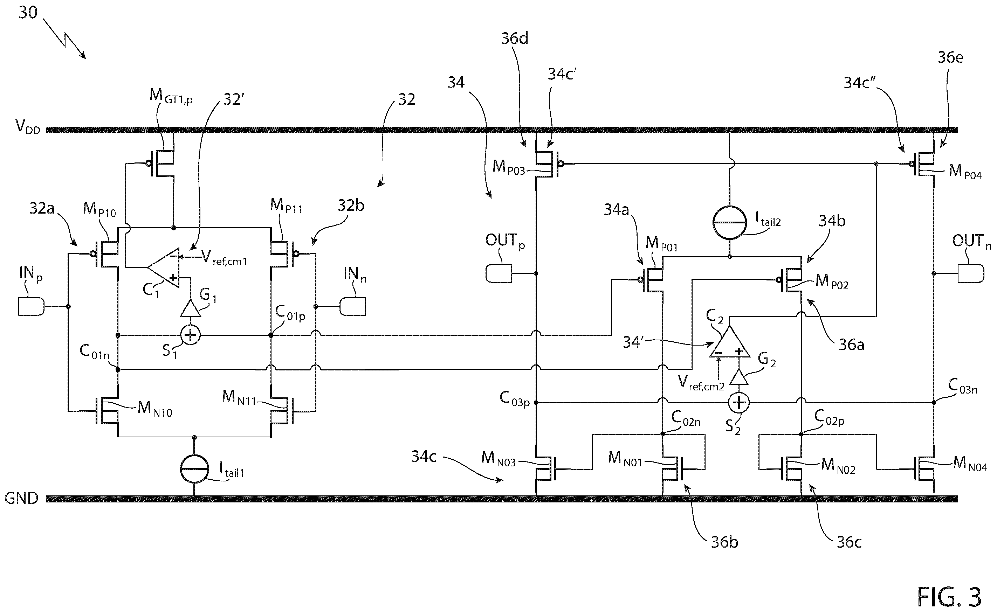

Figure 3 shows an embodiment of an operational amplifier 30, in particular an operational transconductance amplifier (OTA). Therefore, in the following, reference is exemplarily made to the case in which the operational amplifier 30 is an OTA.

The OTA 30 is an operational amplifier of the two-stage type.

In greater detail, in the embodiment of Figure 3, the OTA 30 is of the fully differential type and therefore with two outputs (hereinafter denoted as OUTₚ and OUTₙ).

The OTA 30 is coupled to a first supply rail set to a maximum supply voltage V_{DD} (e.g., equal to about 2V) and to a second supply rail set to a minimum supply voltage (here a reference voltage equal to a ground voltage GND, exemplarily equal to about 0V), to be biased. Therefore, in the following, the first and the second supply rails are also referred to more briefly as the first and the second rails V_{DD} and GND, respectively.

The OTA 30 comprises a first stage 32 with current reuse and a second stage 34 of the rail-to-rail type, cascaded to each other.

The first stage 32 comprises a first inverter (or first first-stage inverter) 32a and a second inverter (or second first-stage inverter) 32b, connected in parallel with each other between the first and the second rails V_{DD} and GND.

The first and the second inverters 32a and 32b are made by using CMOS technology. In other words, the first inverter 32a comprises a MOSFET (or first P-MOSFET) M_{P10} of the P-type and a MOSFET (or first N-MOSFET) M_{N10} of the N-type, complementary to each other, and the second inverter 32b comprises a MOSFET (or second P-MOSFET) M_{P11} of the P-type and a MOSFET (or second N-MOSFET) M_{N11} of the N-type, complementary to each other.

In detail, the first stage 32 also comprises a first tail current generator, configured to generate a first tail current Iₜₐᵢₗ₁ (e.g., equal to about 50 µA) and therefore hereinafter also referred to more simply as the first current generator Iₜₐᵢₗ₁, and a control MOSFET M_{GT1,p}, of the P-type.

In greater detail, the source terminal of the control MOSFET M_{GT1,p} is directly connected to the first rail V_{DD}, the first current generator Iₜₐᵢₗ₁ is directly connected to the second rail GND and the first and the second inverters 32a and 32b are directly connected, in parallel with each other, between the drain terminal of the control MOSFET M_{GT1,p} and the first current generator Iₜₐᵢₗ₁.

The gate terminals of the MOSFETs M_{P10} and M_{N10} are directly coupled to a positive (or non-inverting) input INₚ of the OTA 30, and the gate terminals of the MOSFETs M_{P11} and M_{N11} are directly coupled to a negative (or inverting) input INₙ of the OTA 30.

The source terminals of the MOSFETs M_{P10} and M_{P11} are directly connected to the drain terminal of the control MOSFET M_{GT1,p}, the source terminals of the MOSFETs M_{N10} and M_{N11} are directly connected to the first current generator Iₜₐᵢₗ₁, the drain terminals of the MOSFETs M_{P10} and M_{N10} are directly coupled to each other at a first negative (or inverting) common node C₀₁ₙ, and the drain terminals of the MOSFETs M_{P11} and M_{N11} are directly coupled to each other at a first positive (or non-inverting) common node C₀₁ₚ.

Furthermore, the first stage 32 comprises a first feedback assembly 32'. The first feedback assembly 32' forms, together with the other components of the first stage 32, a first feedback loop, in particular a common-mode one.

In particular, the first feedback assembly 32' comprises a first adder element S₁, a first gain element G₁ and a first subtractor element C₁.

The first adder element S₁ is connected to the first positive common node C₀₁ₚ and to the first negative common node C₀₁ₙ. In particular, the first positive common node C₀₁ₚ and the first negative common node C₀₁ₙ are directly connected to respective inputs of the first adder element S₁, so that the respective voltages are added to each other by the first adder element S₁. For example, the first adder element S₁ is an analog adder, in particular a two-input one.

The first adder element S₁ is in turn connected to the first gain element G₁. In detail, the output of the first adder element S₁ is directly connected to the input of the first gain element G₁, which has a gain equal to 0.5. For example, the first gain element G₁ is an amplifier with a gain equal to 0.5.

Consequently, the first adder element S₁ and the first gain element G₁ allow the common mode (i.e. the half-sum) of the voltages at the first positive common node C₀₁ₚ and at the first negative common node C₀₁ₙ to be calculated.

The output of the first gain element G₁ is then compared with a first common-mode reference voltage V_{ref,cm1} (e.g., equal to about the mean value between the maximum supply voltage V_{DD} and the minimum supply voltage GND, so here for example equal to about 1V), to calculate its difference. In detail, the output of the first gain element G₁ is directly connected to a positive (or non-inverting) input of the first subtractor element C₁, while the first common-mode reference voltage V_{ref,cm1} is applied to the negative (or inverting) input of the first subtractor element C₁. For example, the first subtractor element C₁ is an analog subtractor (e.g., a differential amplifier).

Furthermore, the first subtractor element C₁ also has a first gain A₁ (e.g., equal to about 10). Consequently, the output of the first subtractor element C₁ corresponds to the difference, multiplied by the first gain A₁, between the voltage at the output of the first gain element G₁ and the first common-mode reference voltage V_{ref,cm1}.

The output of the first subtractor element C₁ is then directly connected to the gate terminal of the control MOSFET M_{GT1,p}. In this manner, the output voltage of the first subtractor element C₁, determined on the basis of the comparison between the common mode of the voltages of the first common nodes C₀₁ₚ and C₀₁ₙ and the first common-mode reference voltage V_{ref,cm1}, is used to control the operation of the control MOSFET M_{GT1,p} (therefore of the first stage 32 in general and as to the common mode in particular).

The second stage 34 comprises a first complementary assembly 34a and a second complementary assembly 34b, connected in parallel with each other between the first and the second rails V_{DD} and GND.

The first and the second complementary assemblies 34a and 34b are made by using CMOS technology. In detail, the first complementary assembly 34a comprises a MOSFET (or first pair MOSFET) M_{P01} of the P-type and a MOSFET (or first mirror MOSFET) M_{N01} of the N-type, complementary to each other, and the second complementary assembly 34b comprises a MOSFET (or second pair MOSFET) M_{P02} of the P-type and a MOSFET (or second mirror MOSFET) M_{N02} of the N-type, complementary to each other.

The second stage 34 also comprises a second tail current generator, configured to generate a second tail current Iₜₐᵢₗ₂ (e.g., equal to about 2 µA) and therefore hereinafter also referred to more simply as the second current generator Iₜₐᵢₗ₂. The second current generator Iₜₐᵢₗ₂ is directly connected to the first rail V_{DD} and the first and the second complementary assemblies 34a and 34b are directly connected, in parallel with each other, between the second current generator Iₜₐᵢₗ₂ and the second rail GND.

In particular, the gate terminals of the MOSFETs M_{P01} and M_{P02} are directly coupled to the first positive common node C₀₁ₚ and the first negative common node C₀₁ₙ, respectively. Consequently, the voltage at the first negative common node C₀₁ₙ is used to drive the MOSFET M_{P02}, while the voltage at the first positive common node C₀₁ₚ is used to drive the MOSFET M_{P01}.

The source terminals of the MOSFETs M_{P01} and M_{P02} are directly connected to the second current generator Iₜₐᵢₗ₂, and the source terminals of the MOSFETs M_{N01} and M_{N02} are directly connected to the second rail GND.

The drain terminals of the MOSFETs M_{P01} and M_{N01} are directly coupled to each other at a second negative (or inverting) common node C₀₂ₙ, and the drain terminals of the MOSFETs M_{P02} and M_{N02} are directly coupled to each other at a second positive (or non-inverting) common node C₀₂ₚ.

Furthermore, the gate terminal and the drain terminal of the MOSFET M_{N01} are directly connected to each other and therefore short-circuited, in such a way that the MOSFET M_{N01} operates in a diode-connected transistor mode. Similarly, the gate terminal and the drain terminal of the MOSFET M_{N02} are also directly connected to each other and therefore short-circuited, in such a way that the MOSFET M_{N02} operates in diode-connected transistor mode.

The second stage 34 also comprises an output assembly 34c, in particular comprising a first output subassembly 34c' and a second output subassembly 34c", connected in parallel with each other between the first and the second rails V_{DD} and GND.

The output assembly 34c is made by using CMOS technology. In detail, the first output subassembly 34c' comprises a MOSFET (or first rail P-MOSFET) M_{P03} of the P-type and a MOSFET (or first rail N-MOSFET) M_{N03} of the N-type, complementary to each other, and the second output subassembly 34c" comprises a MOSFET (or second rail P-MOSFET) M_{P04} of the P-type and a MOSFET (or second rail N-MOSFET) M_{N04} of the N-type, complementary to each other.

The gate terminal of the MOSFET M_{N03} is directly connected to the second negative common node C₀₂ₙ, while the gate terminal of the MOSFET M_{N04} is directly connected to the second positive common node C₀₂ₚ. Consequently, the voltages at the second positive common node C₀₂ₚ and the second negative common node C₀₂ₙ are used to control the operation of the MOSFETs M_{N04} and M_{N03}, respectively.

Furthermore, the gate terminals of the MOSFETs M_{P03} and M_{P04} are directly connected to each other.

The source terminals of the MOSFETs M_{P03} and M_{P04} are directly connected to the first rail V_{DD}, in parallel with each other, while the source terminals of the MOSFETs M_{N03} and M_{N04} are directly connected to the second rail GND, in parallel with each other.

The drain terminals of the MOSFETs M_{P03} and M_{N03} are directly connected to each other at a third positive (or non-inverting) common node C₀₃ₚ (also referred to as the rail positive common node C₀₃ₚ) in such a way that they are short-circuited to each other. Similarly, the drain terminals of the MOSFETs M_{P04} and M_{N04} are directly connected to each other at a third negative (or inverting) common node C₀₃ₙ (also referred to as the rail negative common node C₀₃ₙ) so that they are short-circuited to each other.

The third positive common node C₀₃ₚ is directly connected to a positive (or non-inverting) output of the OTA 30, while the third negative common node C₀₃ₙ is directly connected to a negative (or inverting) output of the OTA 30.

In view of what has been described so far, it is clear that the second stage 34 comprises a differential pair 36a (formed by the MOSFETs M_{P01} and M_{P02}), a first current mirror 36b (or positive current mirror, formed by the MOSFETs M_{N01} and M_{N03}), a second current mirror 36c (or negative current mirror, formed by the MOSFETs M_{N02} and M_{N04}), a first rail-to-rail assembly 36d (or positive rail-to-rail assembly, formed by the MOSFETs M_{P03} and M_{N03}) and a second rail-to-rail assembly 36e (or negative rail-to-rail assembly, formed by the MOSFETs M_{P04} and M_{N04}).

In detail, in use, the MOSFETs M_{P01} and M_{P02} of the differential pair 36a receive the voltages at the first positive common node C₀₁ₚ and the first negative common node C₀₁ₙ and convert them into respective currents, which flow towards the first branches of the respective current mirrors 36b and 36c, defined by the MOSFETs M_{N01} and M_{N02}, respectively. In other words, the current mirrors 36b and 36c operate as electronic loads for the differential pair 36a. The currents in the first branches of the current mirrors 36b and 36c are then mirrored in the respective second branches, defined by the MOSFETs M_{N03} and M_{N04}, respectively. Consequently, these currents flow in the respective rail-to-rail assemblies 36d and 36e, originating the output voltages at the positive output OUTₚ and the negative output OUTₙ, respectively.

In particular, the use of current mirrors 36b and 36c allows the information content of the input signals to be transferred from the differential pair 36a (which is not able to provide a rail-to-rail output by itself, due to the presence of the second current generator Iₜₐᵢₗ₂) to the rail-to-rail assemblies 36d and 36e (which instead have the respective outputs OUTₚ/OUTₙ that are symmetrically interposed between the rails V_{DD} and GND and are spaced therefrom only by the MOSFETs M_{P03}, M_{N03} and M_{P04} and M_{N04}, thus allowing the rail-to-rail functionality to be achieved).

Furthermore, the second stage 34 comprises a second feedback assembly 34'. The second feedback assembly 34' forms, together with the other components of the second stage 34, a second feedback loop, in particular a common-mode one.

The first feedback assembly 32' and the second feedback assembly 34' are independent of each other. In more detail, the first feedback assembly 32' is part of the first feedback loop that forms a feedback loop for the common mode of the first stage 32, which is independent of the second feedback loop of which the second feedback assembly 34' is part. In other words, the first and the second stages 32 and 34 are electrically connected to each other through the electrical connections that join the first common nodes C₀₁ₚ and C₀₁ₙ to the respective MOSFETs M_{P01} and M_{P02}. However, this electrical connection is not effective on the common mode, i.e. the output common mode of the first stage 32 does not affect the output common mode of the second stage 34 because it is rejected by the differential pair defined by the MOSFETs M_{P01} and M_{P02}. Therefore, with regards to the common mode, the operation of the first stage 32 is not influenced by the second stage 34 and the operation of the second stage 34 is not influenced by the first stage 32. In other words, the first and the second feedback loops are separate and independent of each other.

In particular, the second feedback assembly 34' comprises a second adder element S₂, a second gain element G₂ and a second subtractor element C₂.

The second adder element S₂ is connected to the third positive common node C₀₃ₚ and the third negative common node C₀₃ₙ. In particular, the third positive common node C₀₃ₚ and the third negative common node C₀₃ₙ are directly connected to respective inputs of the second adder element S₂, so that the respective voltages are added to each other by the second adder element S₂. For example, the second adder element S₂ is an analog adder, in particular a two-input one.

The second adder element S₂ is in turn connected to the second gain element G₂. In detail, the output of the second adder element S₂ is directly connected to the input of the second gain element G₂, which has a gain equal to 0.5. For example, the second gain element G₂ is an amplifier with a gain equal to 0.5.

Consequently, the second adder element S₂ and the second gain element G₂ allow the common mode (or half-sum) of the voltages at the third positive common node C₀₃ₚ and at the third negative common node C₀₃ₙ to be calculated.

The output of the second gain element G₂ is then compared with a second common-mode reference voltage V_{ref,cm2} (e.g., equal to about the mean value between the maximum supply voltage V_{DD} and the minimum supply voltage GND, so here for example equal to about 1V), to calculate its difference. In detail, the output of the second gain element G₂ is directly connected to a positive (or non-inverting) input of the second subtractor element C₂, while the second common-mode reference voltage V_{ref,cm2} is applied to the negative (or inverting) input of the second subtractor element C₂.

For example, the second subtractor element C₂ is an analog subtractor (e.g., a differential amplifier).

Furthermore, the second subtractor element C₂ also has a second gain A₂ (e.g., equal to about 10). Consequently, the output of the second subtractor element C₂ corresponds to the difference, multiplied by the second gain A₂, between the voltage at the output of the second gain element G₂ and the second common-mode reference voltage V_{ref, cm2} .

The output of the second subtractor element C₂ is then directly connected to the gate terminals of the MOSFETs M_{P03} and M_{P04}.

In this manner, the output voltage of the second subtractor element C₂, determined on the basis of the comparison between the common mode of the voltages of the third common nodes C₀₃ₚ and C₀₃ₙ and the second common-mode reference voltage V_{ref,cm2}, is used to control the operation of the MOSFETs M_{P03} and M_{P04} (therefore of the second stage 34 in general and as to the common mode in particular).

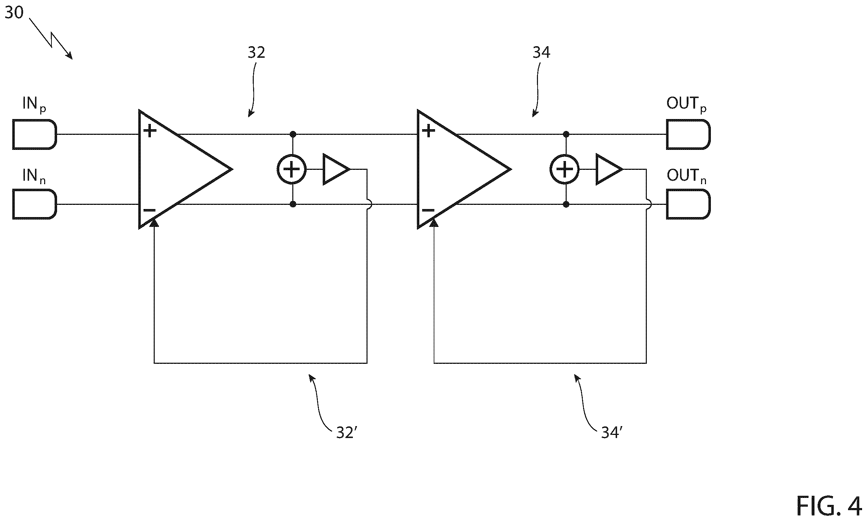

Figure 4 schematically shows a system-level modeling of the OTA 30 of Figure 3.

In particular, from Figure 4 it is clearly understood how the first and the second feedback assemblies 32' and 34' are independent of and not correlated with each other, in such a way that there is no feedback that joins the first and the second stages 32 and 34.

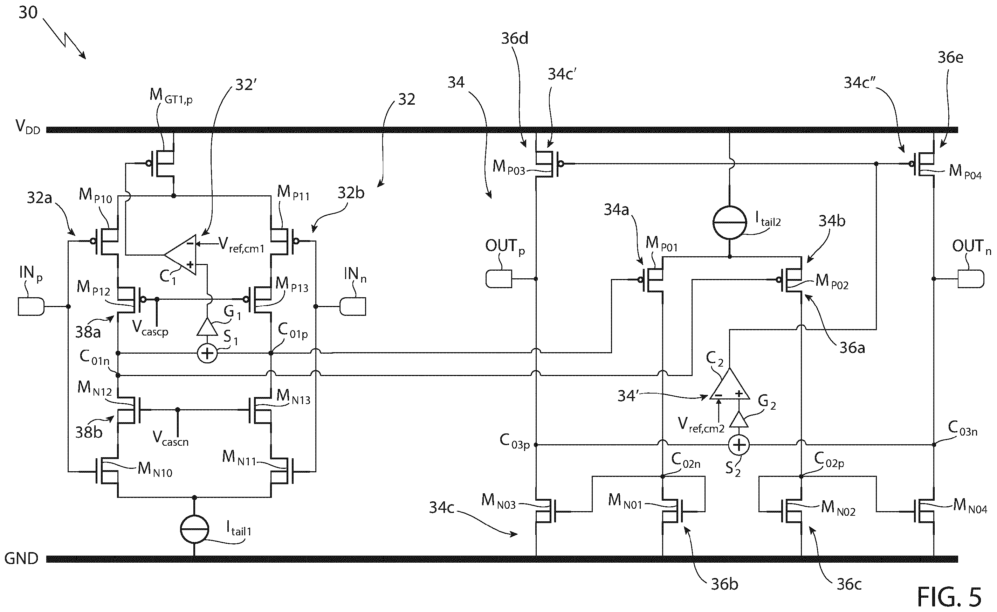

Figure 5 shows a further embodiment of the OTA 30.

The OTA 30 of Figure 5 is substantially similar to the OTA 30 of Figure 3, therefore it is not described herein again except for highlighting its differences with respect to the structure of Figure 3.

In particular, in Figure 5 the first stage 32 also comprises a first cascode assembly (or positive cascode assembly) 38a and a second cascode assembly (or negative cascode assembly) 38b.

In detail, the positive cascode assembly 38a comprises a MOSFET (or first cascode P-MOSFET) M_{P12} and a MOSFET (or second cascode P-MOSFET) M_{P13}, both of the P-type, while the negative cascode assembly 38b comprises a MOSFET (or first cascode N-MOSFET) M_{N12} and a MOSFET (or second cascode N-MOSFET) M_{N13}, both of the N-type.

The MOSFET M_{P12} is cascoded with respect to the MOSFET M_{P10}, the MOSFET M_{P13} is cascoded with respect to the MOSFET M_{P11}, the MOSFET M_{N12} is cascoded with respect to the MOSFET M_{N10}, and the MOSFET M_{N13} is cascoded with respect to the MOSFET M_{N11}.

Furthermore, the gate terminals of the MOSFETs M_{P12} and M_{P13} are directly connected to each other and are configured to receive a cascode voltage (or first cascode voltage) V_{cascp}; similarly, the gate terminals of the MOSFETs M_{N12} and M_{N13} are directly connected to each other and are configured to receive a cascode voltage (or second cascode voltage) V_{cascn}.

The cascode voltages V_{cascp} and V_{cascn} are obtained in a per se known manner and have values such that the cascode assemblies 38a and 38b may work appropriately in cascode mode. For example, the cascode voltage V_{cascn} may be obtained using a further current generator (not shown and connected directly between the first rail V_{DD} and the connection between the gate terminals of the MOSFETs M_{N12} and M_{N13}) and a further MOSFET in diode-connected transistor mode (not shown, of the N-type and with the source terminal directly connected to the first current generator Iₜₐᵢₗ₁ and with the drain terminal directly connected to the connection between the gate terminals of the MOSFETs M_{N12} and M_{N13}); a similar structure may be used to obtain the cascode voltage V_{cascp}.

In greater detail, the source terminals of the MOSFETs M_{P12} and M_{P13} are directly connected to the drain terminals of the respective MOSFETs M_{P10} and M_{P11}, the source terminals of the MOSFETs M_{N12} and M_{N13} are directly connected to the drain terminals of the respective MOSFETs M_{N10} and M_{N11}, the drain terminals of the MOSFETs M_{P12} and M_{N12} are directly connected to each other at the first negative common node C₀₁ₙ, and the drain terminals of the MOSFETs M_{P13} and M_{N13} are directly connected to each other at the first positive common node C₀₁ₚ.

The presence of the cascode assemblies 38a and 38b, together with the fact that the first common-mode reference voltage V_{ref,cm1} is set approximately to the midpoint between the voltages V_{DD} and GND, allows to further increase the gain of the first stage 32 and therefore the accuracy of the OTA 30.

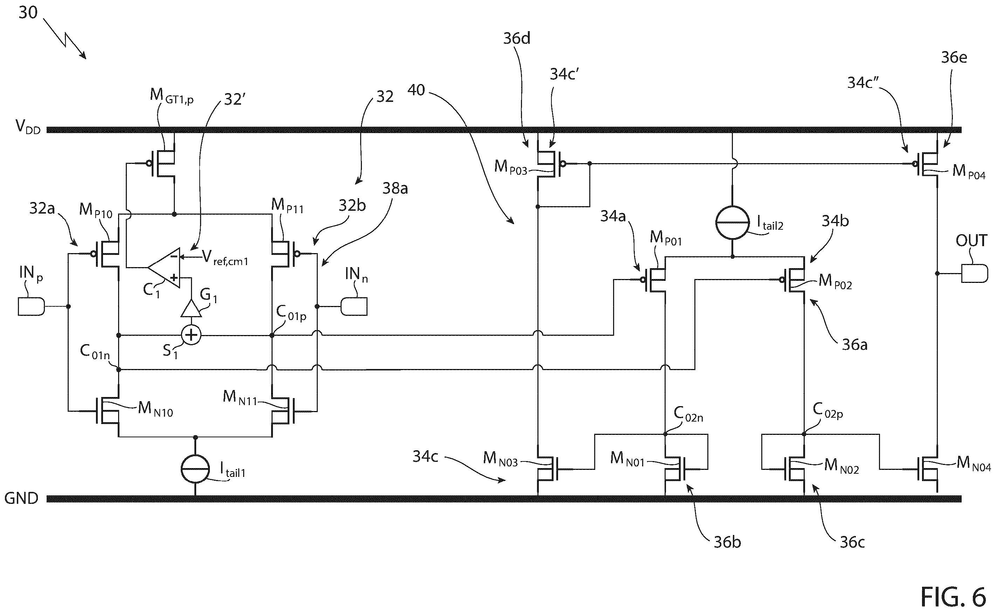

Figure 6 shows a further embodiment of the OTA 30.

In detail, in the embodiment of Figure 6 the OTA 30 is of the single-ended type having an output hereinafter denoted as OUT.

The OTA 30 of Figure 6 is substantially similar to the OTA 30 of Figure 3, therefore it is not described herein again except for highlighting its differences with respect to the structure of Figure 3.

In particular, in Figure 6 the second stage 34 does not have the second feedback assembly 34'.

Furthermore, the second stage 34 has only one output OUT, here exemplarily placed at the third negative common node C₀₃ₙ. Nevertheless, alternatively the output OUT might be placed at the third positive common node C₀₃ₚ by displacing the diode connection from the MOSFET M_{P03} to the MOSFET M_{P04}.

In detail, in the embodiment considered here wherein the output OUT is placed at the third negative common node C₀₃ₙ, the MOSFET M_{P03} is in diode-connected transistor mode (i.e. it has the gate terminal and the drain terminal that are directly connected to each other and therefore short-circuited). This implies that the MOSFETs M_{P03} and M_{P04} form a further current mirror 40 that mirrors the current in the first branch (here defined by the MOSFET M_{P03}) also in the second branch (here defined by the MOSFET M_{P04}), making it possible to use a single output OUT.

In other words, in Figure 6 the second stage 34 has a structure typically known as the symmetric OTA.

From an examination of the characteristics of the invention made according to the present invention, the advantages that it affords are evident.

In particular, the output common mode of the first stage 32 may be set independently of the second stage 34, so the first stage 32 may be biased to its maximum gain point without interferences by the second stage 34.

Furthermore, the second stage 34 is not sensitive to the output common mode of the first stage 32, so there is no need to use MOSFETs with a high threshold voltage Vₜ. This makes the manufacturing process of the OTA 30 simpler and cheaper, and especially makes the OTA 30 more reliable since any tolerances and process variations equally influence all the MOSFETs present, thus making its operation homogeneous.

The OTA 30 has a high accuracy, thanks to the high gain of the first stage 32 (possibly even greater if the first stage 32 comprises the cascode assemblies 38a and 38b).

Furthermore, the second stage 34 is effectively of the rail-to-rail type.

Furthermore, since the output common mode of the first stage 32 is set to the first common-mode reference voltage V_{ref,cm1} thanks to the first feedback loop, this output common mode is not sensitive to PVT variations. Therefore, the first common-mode reference voltage V_{ref,cm1} may be chosen so as to maximize the gain of the first stage 32.

Finally, the cascade of the first and the second stages 32 and 34 makes it possible to have, in particular for fully-differential OTAs such as, for example, those described in reference to Figures 3 and 5, a high common-mode rejection between the inputs INₚ and INₙ and the outputs OUTₚ and OUTₙ, which reduces the positive common-mode feedback. Consequently, the OTA 30 is significantly less prone to the latching problem.

Finally, it is clear that modifications and variations may be made to the invention described and illustrated herein without thereby departing from the scope of the present invention, as defined in the attached claims.

For example, the different embodiments described may be combined to each other to provide further solutions (e.g., the cascode assemblies 38a and 38b of Figure 5 may be similarly used also in the embodiment of Figure 6).

Furthermore, with reference to the second stage 34, although only the structure of Figures 3, 5 and 6 has been described so far, it is clear that this has been done for illustrative and non-limiting purposes and that therefore other rail-to-rail structures may be similarly considered, in lieu of that described so far.

Furthermore, although the case of the control MOSFET M_{GT1,p} of the P-type has been described so far, it is however clear that the case of a control MOSFET of the N-type may also be similarly considered. In this case, the drain terminal of the control MOSFET of the N-type is connected to the source terminals of the MOSFETs M_{N10} and M_{N11}, its source terminal is connected to the second rail GND and its gate terminal is connected to the output of the first subtractor element C₁; instead, the first tail current generator is connected between the first rail V_{DD} and the source terminals of the MOSFETs M_{P10} and M_{P11}.

Furthermore, the minimum supply voltage may be a voltage Vₛₛ different from the ground voltage GND; for example, the voltage Vₛₛ may be a negative voltage.

Furthermore, the structure defined by adder element and gain element effectively allows the calculation of the half-sum of the voltages at the input of the adder element. It is therefore evident that other circuit embodiments that have a similar operation may be considered, as an alternative to that considered exemplarily herein. For example, simpler circuits (e.g., two resistors or two MOSFETs appropriately connected, in a known manner) may be used to perform this common mode calculation function.

## Claims

1. An operational amplifier (30) comprising:
a first stage (32) of the current-reuse type; and
a second stage (34) of the rail-to-rail type, cascaded with respect to the first stage (32),
wherein the first stage (32) comprises a first feedback assembly (32') configured to define a first feedback loop, independent of the second stage (34).

2. The operational amplifier according to claim 1, wherein the operational amplifier (30) is of the transconductance type.

3. The operational amplifier according to claim 1 or 2, wherein the first feedback assembly (32') has a first input, a second input and an output, and
wherein the first feedback assembly (32') is configured to perform a half-sum of respective voltages at the first input and at the second input, and perform a difference between said half-sum and a first common-mode reference voltage (V_{ref,cm1}).

4. The operational amplifier according to claim 3, wherein the first feedback assembly (32') comprises:
a first adder element (S₁) having a first input defining the first input of the first feedback assembly (32'), a second input defining the second input of the first feedback assembly (32'), and an output, the first adder element (S₁) being configured to perform a sum of respective voltages at the first input and at the second input;
a first gain element (G₁) having an input and an output, the input being connected to the output of the first adder element (S₁), the first gain element (G₁) being configured to halve the sum of the voltages at the first input and at the second input of the first adder element (S₁); and
a first subtractor element (C₁) having a first input of the non-inverting type, a second input of the inverting-type, and an output, the first input being connected to the output of the first gain element (G₁), the second input being configured to receive said first common-mode reference voltage (V_{ref,cm1}) and the output defining the output of the first feedback assembly (32'), the first subtractor element (C₁) being configured to perform a difference between said sum and the first common-mode reference voltage (V_{ref,cm1}).

5. The operational amplifier according to any of claims 1-4, further comprising a first supply rail, configured to be set to a maximum supply voltage (V_{DD}), and a second supply rail, configured to be set to a minimum supply voltage (GND; Vₛₛ).

6. The operational amplifier according to claims 3 and 5, having a positive input (INₚ) and a negative input (INₙ),
wherein the first stage (32) comprises a control MOSFET (M_{GT1,p}), of the P-type and with a source terminal connected to the first supply rail,
wherein the first stage (32) further comprises a first inverter (32a) and a second inverter (32b), connected in parallel with each other between the control MOSFET (M_{GT1,p}) and the second supply rail,
wherein the first inverter (32a) comprises a first P-MOSFET (M_{P10}) of the P-type and a first N-MOSFET (M_{N10}) of the N-type, and the second inverter (32b) comprises a second P-MOSFET (M_{P11}) of the P-type and a second N-MOSFET (M_{N11}) of the N-type,
wherein gate terminals of the first P-MOSFET (M_{P10}) and the first N-MOSFET (M_{N10}) are coupled to the positive input (INₚ) and gate terminals of the second P-MOSFET (M_{P11}) and the second N-MOSFET (M_{N11}) are coupled to the negative input (INₙ),
wherein source terminals of the first P-MOSFET (M_{P10}) and the second P-MOSFET (M_{P11}) are connected, in parallel with each other, to a drain terminal of the control MOSFET (M_{GT1,p}) ,
wherein drain terminals of the first P-MOSFET (M_{P10}) and the first N-MOSFET (M_{N10}) are coupled to each other at a first negative common node (C₀₁ₙ), and drain terminals of the second P-MOSFET (M_{P11}) and the second N-MOSFET (M_{N11}) are coupled to each other at a first positive common node (C₀₁ₚ), and
wherein the first input and the second input of the first feedback assembly (32') are connected to the first positive common node (C₀₁ₚ) and the first negative common node (C₀₁ₙ), respectively, and the output of the first feedback assembly (32') is connected to a gate terminal of the control MOSFET (M_{GT1,p}).

7. The operational amplifier according to claims 3 and 5, having a positive input (INₚ) and a negative input (INₙ),
wherein the first stage (32) comprises a control MOSFET of the N-type and with a source terminal connected to the second supply rail,
wherein the first stage (32) further comprises a first inverter (32a) and a second inverter (32b), connected in parallel with each other between the first supply rail and the control MOSFET,
wherein the first inverter (32a) comprises a first P-MOSFET (M_{P10}) of the P-type and a first N-MOSFET (M_{N10}) of the N-type, and the second inverter (32b) comprises a second P-MOSFET (M_{P11}) of the P-type and a second N-MOSFET (M_{N11}) of the N-type,
wherein gate terminals of the first P-MOSFET (M_{P10}) and the first N-MOSFET (M_{N10}) are coupled to the positive input (INₚ) and gate terminals of the second P-MOSFET (M_{P11}) and the second N-MOSFET (M_{N11}) are coupled to the negative input (INₙ),
wherein source terminals of the first P-MOSFET (M_{P10}) and the second P-MOSFET (M_{P11}) are connected, in parallel with each other, to the first supply rail,
wherein drain terminals of the first P-MOSFET (M_{P10}) and the first N-MOSFET (M_{N10}) are coupled to each other at a first negative common node (C₀₁ₙ), and drain terminals of the second P-MOSFET (M_{P11}) and the second N-MOSFET (M_{N11}) are coupled to each other at a first positive common node (C₀₁ₚ), and
wherein the first input and the second input of the first feedback assembly (32') are connected to the first positive common node (C₀₁ₚ) and the first negative common node (C₀₁ₙ), respectively, and the output of the first feedback assembly (32') is connected to a gate terminal of the control MOSFET.

8. The operational amplifier according to claim 6 or 7, wherein the first inverter (32a) further comprises a first cascode P-MOSFET (M_{P12}) of the P-type and a first cascode N-MOSFET (M_{N12}) of the N-type, and the second inverter (32b) further comprises a second cascode P-MOSFET (M_{P13}) of the P-type and a second cascode N-MOSFET (M_{N13}) of the N-type,
wherein the first cascode P-MOSFET (M_{P12}) is cascoded with the first P-MOSFET (M_{P10}), the first cascode N-MOSFET (M_{N12}) is cascoded with the first N-MOSFET (M_{N10}), the second cascode P-MOSFET (M_{P13}) is cascoded with the second P-MOSFET (M_{P11}) and the second cascode N-MOSFET (M_{N13}) is cascoded with the second N-MOSFET (M_{N11}).

9. The operational amplifier according to any of the preceding claims, wherein the operational amplifier (30) is of the fully differential type and has a positive output (OUTₚ) and a negative output (OUTₙ), and
wherein the second stage (34) comprises a second feedback assembly (34') configured to define a second feedback loop, independent of the first stage (32) and the first feedback loop.

10. The operational amplifier according to claim 9, wherein the second feedback assembly (34') has a first input, a second input and an output, and
wherein the second feedback assembly (34') is configured to perform a half-sum of respective voltages at the first input and at the second input, and perform a difference between said half-sum and a second common-mode reference voltage (V_{ref,cm2}).

11. The operational amplifier according to claim 10, wherein the second feedback assembly (34') comprises:
a second adder element (S₂) having a first input defining the first input of the second feedback assembly (34'), a second input defining the second input of the second feedback assembly (34'), and an output, the second adder element (S₂) being configured to perform a sum of respective voltages at the first input and at the second input;
a second gain element (G₂) having an input and an output, the input being connected to the output of the second adder element (S₂), the second gain element (G₂) being configured to halve the sum of the voltages at the first input and at the second input of the second adder element (S₂) ; and
a second subtractor element (C₂) having a first input of the non-inverting type, a second input of the inverting type and an output, the first input being connected to the output of the second gain element (G₂), the second input being configured to receive said second common-mode reference voltage (V_{ref,cm2}) and the output defining the output of the second feedback assembly (34'), the second subtractor element (C₂) being configured to perform a difference between said sum and the second common-mode reference voltage (V_{ref,cm2}).

12. The operational amplifier according to claim 5 and one of claims 10 and 11, wherein the second stage (34) further comprises:
a first rail-to-rail assembly (36d) including a first rail P-MOSFET (M_{P03}), of the P-type, and a first rail N-MOSFET (M_{N03}), of the N-type, which are complementary to each other, extend directly between the first supply rail and the second supply rail and are coupled to each other at a third positive common node (C₀₃ₚ); and
a second rail-to-rail assembly (36e) including a second rail P-MOSFET (M_{P04}), of the P-type, and a second rail N-MOSFET (M_{N04}), of the N-type, which are complementary to each other, extend directly between the first supply rail and the second supply rail, in parallel with the first rail-to-rail assembly (36d), and are coupled to each other at a third negative common node (C₀₃ₙ),
wherein the third positive common node (C₀₃ₚ) defines said positive output (OUTₚ) of the operational amplifier (30) and the third negative common node (C₀₃ₙ) defines said negative output (OUTₙ) of the operational amplifier (30), and
wherein the third positive common node (C₀₃ₚ) also defines the first input of the second feedback assembly (34'), the third negative common node (C₀₃ₙ) also defines the second input of the second feedback assembly (34'), and the output of the second feedback assembly (34') is connected to respective gate terminals of the first rail P-MOSFET (M_{P03}) and the second rail P-MOSFET (M_{P04}).

13. The operational amplifier according to claims 6 or 7, and 12, wherein the second stage (34) further comprises:
a differential pair (36a) including a first pair MOSFET (M_{P01}) and a second pair MOSFET (M_{P02}), of the P-type, wherein a gate terminal of the first pair MOSFET (M_{P01}) is connected to the first positive common node (C₀₁ₚ) and a gate terminal of the second pair MOSFET (M_{P02}) is connected to the first negative common node (C₀₁ₙ);
a first current mirror (36b) including a first mirror MOSFET (M_{N01}), of the N-type, and said first rail N-MOSFET (M_{N03}), wherein the first mirror MOSFET (M_{N01}) is coupled to the first pair MOSFET (M_{P01}) and the first current mirror (36b) is configured to mirror in the first rail-to-rail assembly (36d) a current flowing through the first mirror MOSFET (M_{N01}); and
a second current mirror (36c) including a second mirror MOSFET (M_{N02}), of the N-type, and said second rail N-MOSFET (M_{N04}), wherein the second mirror MOSFET (M_{N02}) is coupled to the second pair MOSFET (M_{P02}) and the second current mirror (36c) is configured to mirror in the second rail-to-rail assembly (36e) a current flowing through the second mirror MOSFET (M_{N02}) .

14. The operational amplifier according to any of claims 1-8, wherein the operational amplifier (30) is of the "single-ended" type and has a single output (OUT).

15. The operational amplifier according to claim 14, wherein the second stage (34) has the structure of a symmetrical operational transconductance amplifier, OTA.
